# EUROPEAN PATENT SPECIFICATION

(11) **EP 1 693 884 B1**
(45) Date of publication and mention of the grant of the patent: **19.10.2011**
(21) Application number: 06250735.5
(22) Date of filing: 10.02.2006
(51) Int. Cl.: H01L 21/00

(54) **Susceptor**
Halter
Suscepteur

(30) Priority: 16.02.2005 JP 2005039218
(43) Date of publication of application: 23.08.2006
(73) Proprietor: Bridgestone Corporation, Tokyo 104-8340 (JP)
(72) Inventor: Kobayashi, Fumiya Bridgestone Corp. Technical Ctr, Kodaira-shi Tokyo 187-8531 (JP)
(74) Representative: Whalley, Kevin

(56) References cited:
- EP-A- 1 058 292
- DE-A1- 3 716 002
- US-A1- 2004 175 939

## Description

The present invention relates to a susceptor. Moreover, the present invention relates to a susceptor made of a sintered silicon carbide.

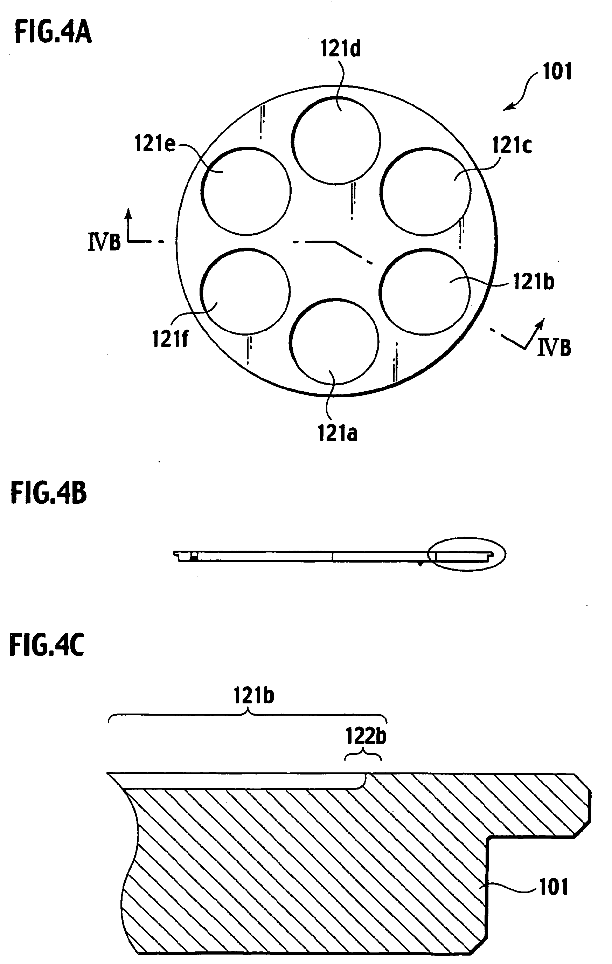

When a thin film is formed on a semiconductor wafer (hereinafter referred to as "wafer") in a gas-phase growth apparatus, the wafer is subjected to gas-phase growth as it is placed on a susceptor.
Wafer pockets 121b having a depressed cross section for storing the wafers are formed on the surface of such a susceptor for use in the gas-phase growth, as shown in Figures 4(a) to 4 (c). The wafer pocket 121b is formed by forming a hole having a capacity sufficient for storing the wafer by polishing on the surface of a base susceptor 101 at a particular interval.

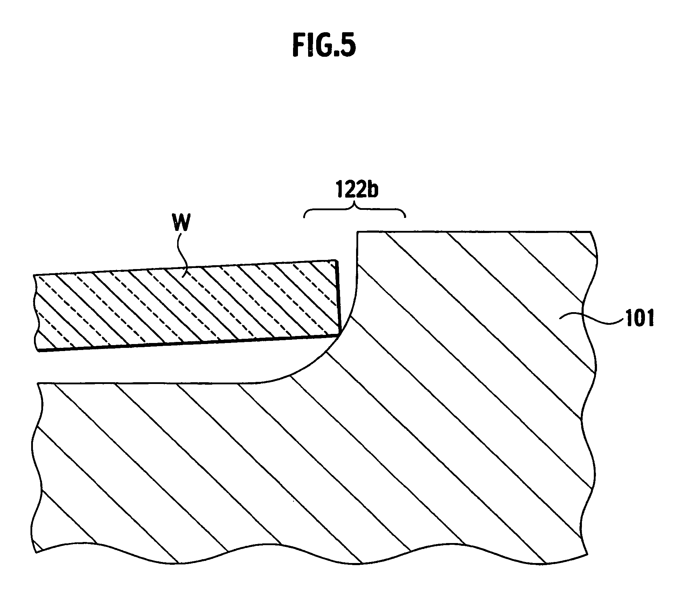

In such a case, there is a technical limitation in polishing the side wall of wafer pocket 121b in the direction perpendicular to the bottom face, and thus, as shown in Figure 4(c), a parabolic-crosssectioned tapered area 122b is formed at the boundary between the side wall and the bottom face of the wafer pocket 121b. As a result, there was a concern that the wafer W is forced to approach the side wall of wafer pocket 121b by centrifugal force, raised and unstabilized in the tapered area 122b, and pushed out of the susceptor as shown in Figure 5 when the susceptor 101 is rotated.

Some methods are disclosed as the means of solving the problems above, e.g., in Japanese Patent Application Laid-Open No. 7-321043. The document discloses a susceptor, including a main susceptor having an entirely flat mounting face for mounting wafers and fixing jigs formed in the grooves of the main susceptor for positioning the wafers. Such a configuration makes the bottom face of wafer pocket flat and,consequently, improves the stability of wafer W.

However, it was difficult to fix the wafer at a predetermined position, because the fixing jig, which is connected to the groove formed on the main susceptor, is dislocated by centrifugal force when the susceptor is rotated.

A susceptor according to the preamble of claim 1 is disclosed in EP-A-1058292.

Thus, there exists a need for a susceptor that can fix wafers at particular positions.

Accordingly, the present invention relates to the following items:
(1) A susceptor, including
   a base plate on which wafers are mounted and
   a ring plate detachably connected to the base plate having hollow wafer pockets for storing the wafers when connected to the base plate, wherein a tapered area is formed on the side wall of each wafer pocket so that the opening diameter of the wafer pocket declines in the direction from the bottom to the top of the wafer pocket, wherein the ring plate is divided into a plurality of units, each having at least one wafer pocket.
(2) The susceptor according to the above-described (1) , wherein the inclination angle between the bottom face and the side wall of the wafer pocket in the tapered area is 60° to 85°.
(3) The susceptor according to the above-described (1) or (2), wherein the susceptor is made of a sintered silicon carbide.
(4) The susceptor according to the above-described (1) or (2), wherein the susceptor is made of a sintered nitrogen-containing silicon carbide.
(5) The susceptor according to any one of the above-described (1) through (5), wherein a wafer-mounting face of the ring plate is flat on its entire surface.

The present invention provides a susceptor that can fix a wafer at a particular position.

### BRIEF DESCRIPTION OF THE DRAWINGS

Figure 1(a) is a top view of a susceptor.
Figure 1(b) is a crosssectional view (IB-IB) of the susceptor.
Figure 1 (c) is a partially expanded crosssectional view of the susceptor.
Figure 2(a) is a top view of another susceptor.
Figure 2(b) is a crosssectional view (IIB-IIB) of the susceptor.
Figure 2(c) is a crosssectional view (IIB-IIB) of the susceptor.
Figure 3(a) is a crosssectional side view illustrating the susceptor when used.
Figure 3 (b) is a partially expanded crosssectional side view illustrating the susceptor when used.
Figure 4(a) is a top view of a conventional susceptor.
Figure 4(b) is a crosssectional view (IVB-IVB) of the conventional susceptor.
Figure 4 (c) is a partially expanded crosssectional view of the conventional susceptor.
Figure 5 is a crosssectional side view illustrating the susceptor when used.

### DESCRIPTION OF THE PREFERRED EMBODIMENT(S)

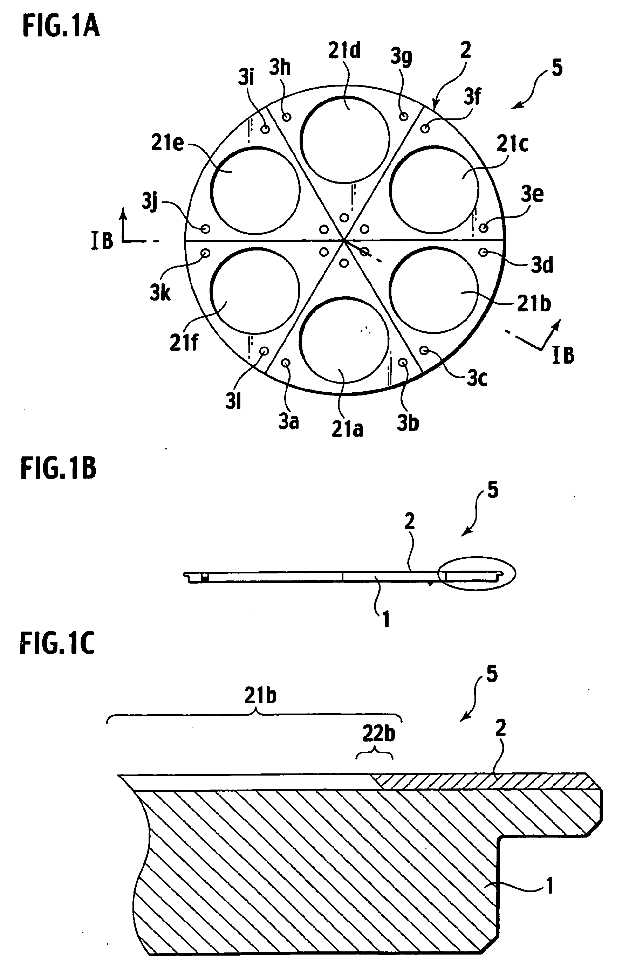

Hereinafter, the present invention will be described with reference to embodiments, but it should be understood that the present invention is not restricted to the following embodiments.
As shown in Figures 1(a) to 1(c), the susceptor 5 in the present embodiment of the present invention has a base plate 1 on which wafers W are mounted and a ring plate 2 detachably connected to the base plate 1 and having hollow wafer pockets 21a to 21f for storing the wafers W when connected to the base plate 1.

The wafer-mounting face of the base plate 1 is preferably flat, because expansion of the contact area between the wafer W and the base plate 1 (bottom of wafer pocket) when the wafer W is mounted leads to increased stability of the wafers W. The planarity of the wafer-mounting face of base plate 1 is preferably, approximately 10 to 20 µm.

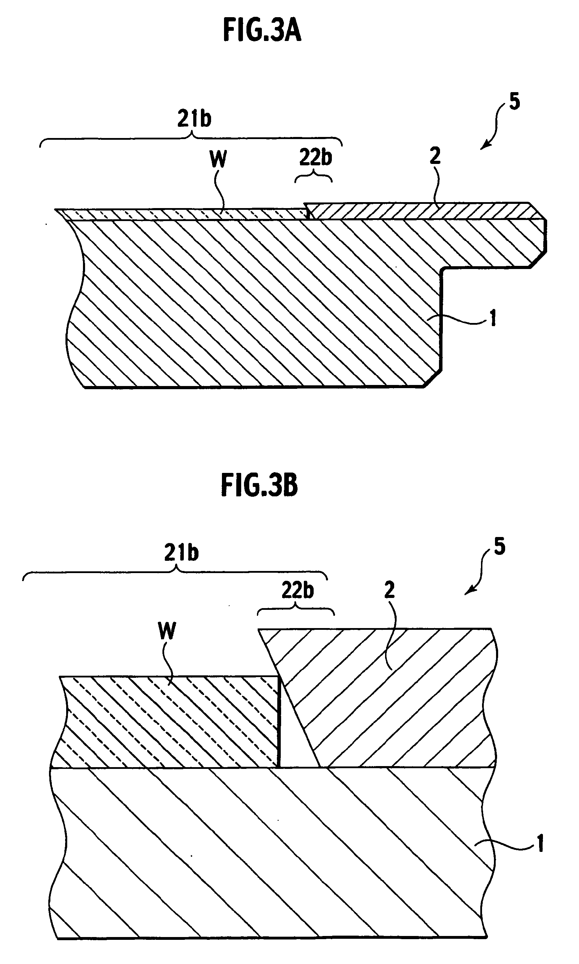

As shown in Figure 1(a), the ring plate 2 has multiple wafer pockets 21a to 21f for storing wafers W arranged at almost the same interval. As shown in Figure 1(c), the side wall of wafer pocket 21b has an area 22b tapered so that the opening diameter of the wafer pocket 21b declines gradually from the bottom to the top of the wafer pocket 21b. As shown in Figures 3 (a) and 3 (b) , presence of a tapered area 22b having a certain inclination angle on the side wall of wafer pocket 21b allows the wafer W to be pressed downward by the tapered area 22b of wafer pocket 21b during use of the susceptor 5. Thus, the wafer W is fixed at a predetermined position, and dislocation of the wafer W is prevented effectively.

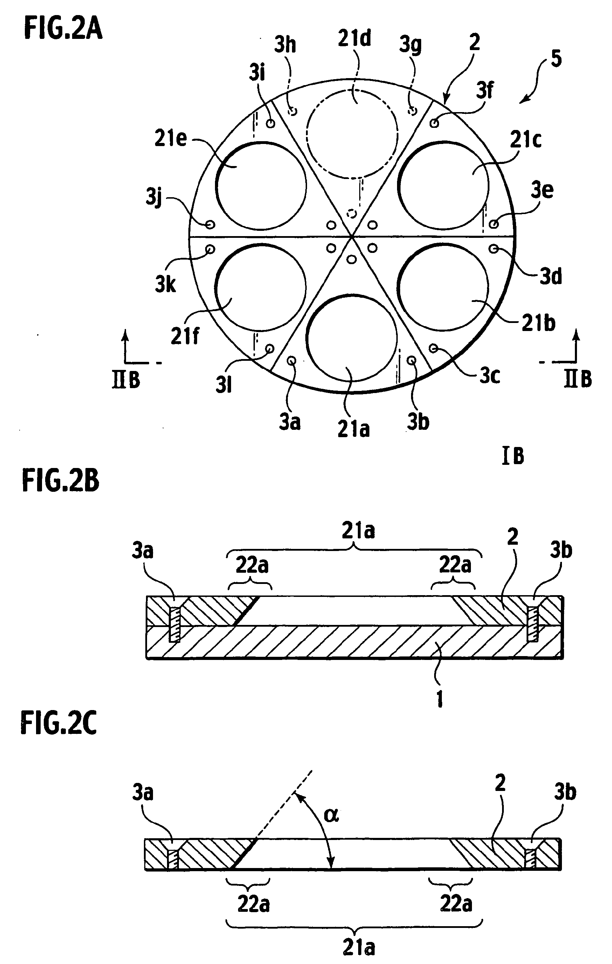

As shown in Figure 2 (c) , the inclination angle a in the tapered area 22a between the bottom face and the side wall of wafer pocket 21a is preferably 60° to 85° and more preferably 70° to 80°, because an angle greater than the upper limit makes the wafer W less reliably fixed in the wafer pocket 21a and lowers the strength of fixation, and an angle smaller than the lower limit value makes the wafer W less tightly pressed during use of the susceptor 5.

As shown in Figures 2(a) and 2(b), the ring plate 2 is detachably connected to the base plate 1 with bolts 3a to 31. Thus, because the ring plate is detachable, it is possible to use the system for wafers in different sizes easily by exchanging a ring plate 2 with another having wafer pockets 21a to 21f having a desirable opening diameter. It also becomes easier to make the side wall of wafer pockets 21a to 21f tapered at a desirable inclination angle and thus to fix wafers W more tightly, by making the susceptor detachable.

The ring plate 2 is preferably detachable, as it is divided into pieces. As shown in Figures 4(a) to 4(c), conventional susceptors 101 had an integral structure having wafer pockets 121a to 121f formed on the surface of the main susceptor. Accordingly, even when only part of a susceptor is damaged by contact with an arm during conveyance of wafer, the entire susceptor 101 should be replaced. However, as shown in Figure 2 (a) , it is possible to replace only damaged part of the ring plate 2, by making the ring plate divided into pieces as indicated by virtual lines. As shown in Figure 2(a), the ring plate 2 is preferably divided into units each containing at least one wafer pocket.

The base plate 1 and the ring plate 2 are preferably made of sintered silicon carbide, because sintered silicon carbide is superior in strength and dimensional stability and favorable in purity and gas resistance, giving a susceptor resistant to distortion or contamination even after use for an extended period of time. The base plate 1 and the ring plate 2 are preferably made of a sintered nitrogen-containing silicon carbide, because presence of nitrogen therein allows preparation of a ring plate 2 having tapered areas 22a to 22f tapered at a desired inclination angle by electric discharge machining. In addition, the base plate 1 and the ring plate 2 are preferably made of the same material, because it leads to improvement of the uniformity in heat distribution in a susceptor and makes it less vulnerable to damage because of the same thermal expansion.
The tapered areas 22a to 22f in the wafer pocket 21a to 21f of ring plate 2 can be formed, for example, by polishing or electric discharge machining.

### (Preparation of susceptor)

A production method by hot pressing is described below as an example of the method of producing the susceptor. The hot pressing method is described first.

### (Hot pressing)

Hereinafter, a method of producing silicon carbide for use in production of the susceptor will be described. The method of producing the susceptor in the present embodiment employs a sintered silicon carbide having a free-carbon content of 2 to 10 wt %. Such a sintered silicon carbide is prepared by sintering a mixture of a silicon carbide powder and a non-metal sintering aid.

The silicon carbide powder is described first. Examples of the silicon carbide powders for use include a-, β-, and amorphous silicon carbide powders or the mixture thereof, and the like; and commercial products may also be used. Among them, β-silicon carbide powder is used favorably. The particle diameter of the silicon carbide powder for use is preferably smaller, preferably, approximately 0.01 to 10 µm and more preferably 0.05 to 2 µm, for increase in the density of sintered silicon carbide. A particle diameter of smaller than 0.01 µm is unfavorable, because it makes the handling in processing steps such as metering and mixing more difficult, while a particle diameter of greater than 10 µm is also unfavorable, because it makes the specific surface area of the powder, i.e., the contact area of a particle with another neighboring particle, smaller and makes it difficult to increase the density of silicon carbide.

Use of a high-purity silicon carbide powder is preferable, as it gives a high-purity sintered silicon carbide. The high-purity silicon carbide powder is prepared, for example, by mixing a silicon compound (hereinafter referred to as "silicon source"), an organic material generating carbon by heating, and a Z polymerization catalyst or a crosslinking catalyst, and sintering the solid mixture thus obtained in a non-oxidative atmosphere. Any of liquid and solid compounds maybe used as the silicon source, but at least one liquid compound is used. Examples of the liquid silicon sources include polymers of a (mono-, di-, tri-, or tetra-)alkoxysilane, and the like. Among the alkoxysilane polymers, tetraalkoxysilane polymers are usedfavorably. Typical examples thereof include methoxysilane, ethoxysilane, propoxysilane, butoxysilane and the like; and ethoxysilane is preferable from the point of handling. When the tetraalkoxysilane polymer has a polymerization degree of approximately 2 to 15, it becomes a low-molecular weight liquid polymer (oligomer). In addition, there are some liquid silicate polymers having a high polymerization degree. An example of the solid silicon source that may be used in combination with a liquid silicon source is silicon carbide. Examples of the silicon carbides include silicon monoxide (SiO), silicon dioxide (SiO₂), as well as silica sol (colloidal ultrafine silica-containing dispersion, having OH and alkoxy groups in the colloid molecule), fine silica, quartz powder, and the like. Among these silicon sources, tetraalkoxysilane oligomers superior in homogeneity and handling efficiency, mixtures of a tetraalkoxysilane oligomer and fine powdery silica, and the like are preferable. These silicon sources are preferably higher in purity, and specifically, the initial impurity content thereof is preferably 20 ppm or less and more preferably 5 ppm or less.

A liquid organic material may be used alone or in combination with a solid organic material as the organic material generating carbon by heating. An organic material having a high residual carbon rate that polymerizes or crosslinks by catalysis or heating is preferable. Typical favorable examples thereof includemonomersandpre-polymersforphenolresins,furanresins, polyimide, polyurethane, and polyvinylalcohol, and the like. In addition, cellulose, sucrose, pitch, liquefied tar, and the like may also be used. Among them, resole phenol resins are preferable, from the points of thermal decomposability and purity. The purity of the organic material may be adjusted according toapplications. If a particularly high-purity silicon carbide powder is desirable, use of an organic material containing impure elements in amounts respectively of less than 5 ppm is preferable.

A favorable range of the blending ratio of silicon source to organic material may be determined by using the carbon/silicon molar ratio (hereinafter referred to as "C/Si") as an indicator. The C/Si ratio is a value based on the analytical results obtained by elemental analysis of the silicon carbide intermediate prepared by carbonizing a mixture of the silicon source and the organic material at 1, 000°C. As shown in the following Reaction Formula, carbon reacts with silicon oxide, forming silicon carbide.

Formula (I): SiO₂ + 3C → SiC + 2CO

Accordingly, stoichiometrically, a C/Si value of 3.0 indicates a free-carbon content of 0% in the silicon carbide intermediate, but,in practice, free carbon is generated even at a lower C/Si value by diffusion of SiO₂ gas and others. Because the free carbon inhibit growth of granules, the C/Si value is preferably determined according to the desirable diameter of powder particle, and the silicon source and the organic material are blended at the ratio. For example, it is possible to avoid generation of free carbon by blending a silicon source and an organic material at a C/Si ratio in the range of 2.0 to 2.5, when they are sintered at approximately 1 atmospheric pressure and 1,600°C or higher. Blending thereof at a C/Si ratio of 2.5 under the same condition results in drastic increase in the amount of free carbon generated, giving a silicon carbide powder having a smaller particle diameter. Thus, the blending ratio is determined according to applications. The operation and effect of the free carbon derived from silicon carbide powder is much weaker than those of the free carbon generated from sintering aid, and thus, the free carbon derived from silicon carbide powder does not influence significantly on the effects of the present embodiment.

The content of the impurity carbon in silicon carbide powder is preferably, approximately 30 wt % or more and approximately 40 wt % or less. The carbon content in silicon carbide (SiC) is theoretically, approximately 30 wt %, but it decreases to less than 30 wt % when non-carbon impurities are contained and increases to more than 30 wt % when carbonic impurities are contained. As described above, the silicon carbide powder obtained by sintering silicon dioxide together with an organic material, which contains carbonic impurities, has a carbon content of greater than 30 wt %. Thus, a carbon content in silicon carbide powder at less than 30 wt %, which leads to a high non-carbon impurity rate, is undesirable from the point of purity. On the other hand, a carbon content of more than 40 wt %, which leads to decrease in the density of the sintered silicon carbide obtained, is undesirable from the points, for example, of strength and oxidation resistance.

A solid silicon carbide intermediate can be prepared by hardening a mixture of a silicon source and an organic material. Examples of the hardening methods include those of using a crosslinking reaction, a hardening reaction with a curing catalyst, and an electron beam or a radiation ray, and the like. The hardening catalyst for use may be selected properly according to the organic material used, and examples thereof include acids such as toluenesulfonic acid, toluenecarboxylic acid, acetic acid, oxalic acid, hydrochloric acid and sulfuric acid, amines such as hexamine, and the like, when a phenol or furan resin is used as the organic material. The solid intermediate containing a silicon source and an organic material is carbonized as needed by heating. The carbonization is carried out by heating in a non-oxidative atmosphere such as of nitrogen or argon at 800°C to 1,000°C for 30 to 120 minutes . Additional heating in the non-oxidative atmosphere at 1, 350°C to 2,000°C gives silicon carbide. The sintering temperature and the sintering period are decided adequately, because they affect, for example, the particle diameter of the silicon carbide powder obtained, but sintering at a temperature of 1,600 to 1,900°C is efficient and preferable. The method for obtaining a high-purity silicon carbide powder described above is described in detail in Japanese Patent Application Laid-Open No. 9-48605.

Hereinaf ter, the non-metal sintering aid will be described. The sintered silicon carbide used in the present embodiment has a free-carbon content of 2 to 10 wt %. The free carbon derives from an organic material used as non-metal sintering aid, and it is possible to adjust the free-carbon content in the range above by adjusting the addition condition, for example, the amount of non-metal sintering aid added.

As described above, the non-metal sintering aid used is a material containing an organic material that serves as a free carbon source, i.e., that generates carbon by heating (hereinafter referred to as "carbon source"). The organic material described above may be used alone as it is or in combination after it is deposited on the surface of a silicon carbide powder (particle diameter: approximately 0.01 to 1 µm) may be used as the sintering aid, but use of the organic material alone is preferable from the point of its effects. Typical examples of the organic materials generating carbon under heat include materials having a high residual carbon rate such as coal tar pitch, pitch tar, phenol resins, furan resins, epoxy resins, phenoxy resins, various sugars including monosaccharides such as glucose, oligosaccharides such as sucrose, and polysaccharides such as cellulose and starch, and the like. For mixing the organic material homogeneously with the silicon carbide powder, the organic material is preferably liquid at room temperature, soluble in solvent, or thermoplastic or softened, for example, melted by heat. Among them, use of a phenol resin, which improves the strength of sintered silicon carbide, is preferable, and use of a resole phenol resin is particularly preferable. The action mechanism of these organic materials is still unclear, but it seems that the organic material generates inorganic carbon compounds such as carbon black and graphite in the system when heated and the inorganic carbonic compounds act effectively as sintering aids. However, it is not possible to obtain the same effects if carbon black or the like is used as the sintering aid.

The non-metal sintering aid may be dissolved in an organic solvent as needed, and the solution and the silicon carbide powder mixed. The organic solvent used varies according to the non-metal sintering aid used, and, when a phenol resin is used as the sintering aid, the solvent is preferably, for example, a lower alcohol such as ethyl alcohol, ethyl ether, acetone, or the like. For preparation of a high-purity sintered silicon carbide, use of a high-purity silicon carbide powder and sintering aid and an organic solvent lower in impurity content is preferable.

The amount of the non-metal sintering aid added to the silicon carbide powder is decided properly so as to give a free-carbon content of 2 to 10 wt % in sintered silicon carbide. A free-carbon content outside the range above may result in insufficient chemical conversion to SiC, which is progressing during "bonding" treatment, and insufficient bonding among sintered silicon carbide particles. The free-carbon content (wt %) can be determined by heating a sintered silicon carbide under oxygen atmosphere at 800°C for 8 minutes, measuring the amounts of CO₂ and CO generated with a carbon analyzer, and calculating from the measured values. The amount of the sintering aid to be added varies according to the kind of the sintering aid used and the amount of the surface silica (silicon oxide) on the silicon carbide powder. A rough estimate of addition amount is calculated by determining the amount of silica (silicon oxide) on the surface of silicon carbide quantitatively by using an aqueous hydrogen fluoride solution and calculating the stoichiometric amount sufficient for reducing the silicon oxide (amount calculated according to Formula (I)). Taking into consideration the rough estimate and the rate of the non-metal sintering aid generating carbon by heating, the addition amount can be determined to give a free-carbon content in the range described above. The non-metal sintering aid for sintered silicon carbide described above is described in more detail in Japanese Patent Application No. 9-041048.

Hereinafter, the method of sintering a mixture of a silicon carbide powder and a non-metal sintering aid will be described. The silicon carbide powder and the non-metal sintering aid are mixed to homogeneity. As described above, a solution of the sintering aid dissolved in an organic solvent may be used for obtaining a homogeneous mixture. Examples of the mixing methods include known methods such as those using a mixer or a planetary ball mill, and the like. The apparatus used for mixing is preferably an apparatus made of a synthetic resin material for prevention of contamination of metal impurities, and the mixing is preferably performed sufficiently for about 10 to 30 hours and more preferably for 16 to 24 hours. After sufficient mixing, the solvent is removed, and the mixture is evaporated to dryness. The mixture is then fractionated through a sieve, to give a raw mixture powder. A granulating machine such as spray dryer may be used in drying.

The raw powder thus obtained is then placed in a mold. Use of a graphite mold is preferable, as it prevents contamination of the sintered silicon carbide with metal impurities. Even a metal mold may be used favorable, if the contact area is made of graphite or coated with a poly-tetra-fluoroethylene sheet (trade name: Teflon® sheet) so that the raw powder does not become in direct contact with the metal area of the mold. In particular if production of a high-purity sintered silicon carbide is desirable, a high-purity graphite material is preferably used as the mold, the heat insulator of oven, and the like. Specific examples thereof include graphite materials and the like that are sufficiently pre-baked at a temperature of 2, 500°C or higher that do not generate impurities during use at high temperature.

The raw powder placed in the mold is then processed by hot pressing. The hot-pressing pressure is not particularly limited, and preferably in the wide range of 300 to 700 kgf/cm². However, when the raw powder is pressurized at 400 kgf/cm² or more, materials that are superior in pressure resistance should be used for the parts for hot-pressing such as die and punch.
The hot pressing is performed at a temperature of 2,000°C to 2,400°C, but heating to the hot-press processing temperature is preferably performed gradually and stepwise. It is possible to advance the chemical change as well as the change in state sufficiently by such heating, and consequently, to avoid contamination with impurities, cracking and void generation. A favorable example of the heating process is described below. First, a mold containing 5 to 10 g of raw powder is placed in an oven, and the oven is deaerated into vacuum at 10⁻⁴ torr. The oven is then heated gradually from room temperature to 200°C and kept at 200°C for approximately 30 minutes. It is then heated to 700°C over a period of 6 to 10 hours and kept at 700°C for 2 to 5 hours. In the heating process from room temperature to 700°C, water and organic solvents absorbed are eliminated and carbonization of the non-metal sintering aid progresses. The period of heating at a constant temperature varies according to the size of sintered silicon carbide and may be decided suitably. It is possible to judge whether the constant-temperature period is sufficient, by determining the point at which decrease in the degree of vacuum stops declining to some extent as an indicator. The oven is then further heated to from 700°C to 1,500°C over a period of 6 to 9 hours and kept at 1,500°C for approximately 1 to 5 hours. While the oven is kept at a temperature of 1,500°C, a reduction reaction converting silicon oxide into silicon carbide progresses (Formula (I)). An insufficient constant-temperature period is undesirable, as it leaves the silicon dioxide unreacted on the surface of silicon carbide powder, inhibiting densification of the particles and causing growth to larger granules. It is possible to judge whether the constant-temperature period is sufficient, by termination of generation of by-product carbon monoxide, i.e., by determining the point at which decrease in the degree of vacuum stops declining to some extent and the vacuum in the oven returns back to the pressure when the reductive reaction is initiated at 1300°C as an indicator.
The hot pressing is preferably performed, after the oven is heated to approximately 1500°C, at which sintering is initiated, and then, the air in the oven is substituted with an inert gas to leave the internal oven in a non-oxidative atmosphere. Nitrogen, argon, or other gas is used as the inert gas, but use of argon gas, which is unreactive even at high temperature, is preferable. If a high purity sintered silicon carbide is desirable, the inert gas used should also be highly pure. After leaving the internal oven in the non-oxidative atmosphere, the oven is heated to a temperature of 2,000°C to 2,400°C and pressurized to a pressure of 300 to 700 kgf/cm². A maximum temperature of lower than 2,000°C is insufficient in increasing the density of silicon carbide. On the other hand, a maximum temperature of higher than 2, 400°C, which leads to sublimation (decomposition) of the powder or the raw molding material, is undesirable. The oven is preferably heated from approximately 1,500°C to maximum temperature over a period of 2 to 4 hours and kept at the maximum temperature for 1 to 3 hours. Sintering progresses rapidly at 1,850 to 1,900°C, and completes while the oven is kept at the maximum temperature. Alternatively, a pressurization condition of lower than 300 kgf/cm², which leads to insufficient densification, and that of higher than 700 kgf/cm², which leads to breakdown of the graphite mold, are both undesirable from the point of productivity. The pressure is preferably, approximately 300 to 700 kgf/cm², for prevention of abnormal growth of particles.

The sintered silicon carbide used is preferably densified more; a density of 2.9 g/cm³ or more and a void rate of 1% or less are preferable; and a density of 3.0 g/cm³ or more and a void rate of 0.8% or less are particularly preferable. Use of a highly densified sintered silicon carbide results in improvement in the mechanical properties, such as bending strength and breaking strength and electrical physical properties, of the silicon carbide plate obtained. In addition, use of a highly densified sintered silicon carbide is desirable, as the particles therein are smaller in size and the sintered silicon carbide plate is resistant to staining. On the other hand, use of a low-density, for example porous, sintered silicon carbide leads to deterioration in the heat resistance, oxidation resistance, chemical resistance, and mechanical strength of the silicon carbide plate obtained and also to insufficient bonding strength.

As a method of densifying the sintered silicon carbide further, the silicon carbide may be processed in a molding step previously to the sintering step. The molding is performed at a temperature and a pressure relatively lower than those in the sintering step. The molding step allows compression of a bulky powder (into a molding smaller in volume), and thus, it is possible to produce a large-sized molding easily by repeating the step severaltimes. Typical conditions of the molding step in advance to the sintering step are summarized below. A raw powder obtained by mixing a silicon carbide powder and a non-metal sintering aid uniformly is placed in a mold, heated therein to a temperature of 80°C to 300°C, preferably 120°C to 140°C, and pressurized at a pressure of 50 kgf/cm² to 100 kgf/cm² for 5 to 60 minutes, preferably for 30 to 40 minutes, to give a molded article. The heating temperature may be decided properly according to the properties of the non-metal sintering aid used. The density of the molded article obtained is preferably adjusted to 1.8 g/cm² or more when a powder having an average diameter of 1 µm is used and to 1.5 g/cm² when a powder having an average diameter of 0.5 µm is used. A density of the molded article used in the range is favorable, as a molded article having such a density gives a high-density sintered silicon carbide. The molded article obtained may be machined to make the molded article compatible with the mold used in the sintering step.

The total content of the impurity elements (elements having an atomic number of 3 or more, excluding C, N, O, and Si, in the Periodic Table of IUPAC Nomenclature of Inorganic Chemistry, Revised Ed., 1930) in the sintered silicon carbide used in the present embodiment is preferably 5 ppm or less, because such a sintered silicon carbide can be used in processes demanding high cleanliness such as semiconductor-manufacturing process. The total content is more preferably 3 ppm or less and particularly preferably 1 ppm or less. However, the impurity content determined by chemical analysis only has a meaning as a reference value, when the silicon carbide is processed in practice. for example, the degree of the stain resistances of silicon carbide plates may vary even when the impurity contents are the same, depending on whether the impurities are distributed evenly or locally. It is possible to obtain a sintered silicon carbide having an impurity content of 1 ppm or less, by using the material and the sintering method exemplified specifically above. For reduction of the impurity-element content of sintered silicon carbide, it is also possible to use, for example, a method of reducing the impurity-element contents in the rawmaterials used (e.g., silicon carbide powder and non-metal sintering aid) and in the inert gas to 1 ppm or less, or removing impurities by adjusting various sintering conditions such as sintering period and temperature. The impurity elements are the same as those described above, i.e., elements having an atomic number of 3 or more, excluding C, N, O, and Si, in the Periodic Table of IUPAC Nomenclature of Inorganic Chemistry, Revised Ed., 1930.

As for other physical properties of the sintered silicon carbide used in the present embodiment, the bending strength thereof at room temperature is preferably 550 to 800 kgf/mm²; Young's modulus, 3.5x10⁴ to 4.5x10⁴; Vickers hardness, 550 to 800 kgf/mm²; Poisson's ratio, 0.14 to 0.21; thermal expansion coefficient, 3.8x10⁻⁶ to 4.2x10⁻⁶ 1/°C; thermal conductivity, 150 W/m.K or more; specific heat 0.15 to 0.18 cal/g·°C; thermal shock resistance, 500 to 700 ΔT°C; and resistivity 1 Ω·cm, because such a silicon carbide composite is favorable in various characteristics. The sintered silicon carbides described in Japanese Patent Application No. 9-041043 filed by the inventors may be used as the sintered silicon carbide in the present embodiment.

### (Method of producing susceptor)

(a) A base plate 1 and a ring plate 2 constituting the susceptor shown in Figure 1(a) to 1(c) are prepared by the hot-pressing method.

(b) Then, the wafer-mounting face of the base plate 1 is polished until the surface becomes planar.

(c) Tapered areas 22a to 221 are then formed by electric discharge machining on the internal side wall of the openings in the ring plate 2 that form wafer pockets 21a to 211 when the ring plate is connected to the base plate 1.

(d) The base plate 1 and the ring plate 2 are polished more thoroughly.

(e) The ring plate 2 is then connected to the base plate 1 with bolts 3a to 31. In this manner, a susceptor is produced.

It is possible to prepare a high-purity, high-density, and high-toughness sintered silicon carbide (susceptor 5) by the production method above. The production equipment by the hot-pressing method is not particularly limited, if it satisfies the heating condition in the present embodiment described above, and any one of known ovens and reactors may be used.

Complicated machining of the surface of susceptor has been needed for production of conventional susceptors. For example, wafer pockets were formed on a susceptor surface, and a groove for fixing a wafer is formed on the peripheral edge of each wafer pocket (see Japanese Patent Application Laid-Open No. 7-321043). On the other hand, in the susceptor 5 in the present embodiment, the ring plate 2 is detachable and the wafer pockets 21a to 21f are formed when the ring plate 2 is connected onto the base plate 1; and thus, it is possible to produce the susceptor 5 easily without complicated machining as that for convention susceptors. For example, it is possible to flatten the bottom face of the wafer pockets 21a to 21f easily by polishing the surface of the base plate 1, while the ring plate 2 is removed from the base plate. As shown in Figures 3 (a) and 3 (b) , it is also possible to make tapered areas 22a to 22f having a linear cross section easily on the wall of the wafer pockets 21a to 21f, for example, by electric discharge machining of the detached ring plate 2. Presence of such tapered areas 22a to 22f improves the efficiency in holding the wafer W. Thus, there is no need for the fixing jigs connected to the peripheral edge of wafer pockets, which are needed in conventional susceptors. It is also possible to remove the parabolic-crosssectioned tapered area 122b shown in figure 5, which was difficult to remove, by connecting the ring plate 2 to the base plate 1.

The susceptor 5 obtained contains a smaller amount of residual silicon, and has a structure wherein the silicon carbide particles are dispersed evenly. The susceptor 5 obtained in the present embodiment has a structure having a density of 2.9 g/cm³ or more wherein isotropic silicon particles having an average diameter of 2 to 10 µm are dispersed evenly. Thus, it can be used as a structural part smaller in fluctuation of its density and others. Considering the reports that sintered materials having a density of less than 2.9 g/cm³ generally lead to deterioration in mechanical properties such as bending and breaking strengths and electrical physical properties and to growth of particles and associated deterioration in stain resistance, it can be said that the susceptor 5 obtained in the present embodiment has favorable mechanical and electrical properties. The density of the susceptor 5 in a preferable embodiment is 3.0 g/cm³ or more.

The total impurity content in the susceptor 5 obtained in the present embodiment is less than 10 ppm, preferably less than 5 ppm, more preferably less than 3 ppm, and still more preferably less than 1 ppm. It is possible to reduce the total content of the impurities other than silicon, carbon, and oxygen contained in the susceptor 5 to less than 1 ppm, by the production method including the steps of mixing a liquid silicon compound, a non-metal sintering aid, and a polymerization or crosslinking catalyst uniformly, heating and carbonizing the solid mixture thus obtained under non-oxidative atmosphere, and sintering the solid matter additionally under non-oxidative atmosphere. The nitrogen-content of the susceptor 5 obtained in the present embodiment is 150 ppm or more.

As for the other preferable physical properties of the susceptor 5 obtained in the present embodiment, for example, the bending strength thereof at room temperature is 400 MPa to 700 MPa; Vickers' hardness, 1,500 kgf/mm² or more; Poisson's ratio, 0.14 to 0.21; coefficient of thermal expansion, 3.8×10⁻⁶ to 4.5x10⁻⁶ (°C⁻¹); thermal conductivity, 150 W/m·k or more; specific heat, 0.60 to 0.70 J/g.K; and resistivity, 1x10⁻¹ Ω·cm or less.

The susceptor 5 thus obtained in the present embodiment preferably has the following physical properties.
The volume resistance of the susceptor 5 is preferably 1 Ω·cm or less, and 0.5 Ω·cm to 0.05 Ω·cm in a more preferable embodiment. The total impurity-element content of the susceptor 5, i.e., content of inevitable elements other than the silicon and carbon contained in the susceptor 5, is less than 5 ppm. The density of the susceptor 5 is 2.9 g/cm³ or more, and 3.00 to 3.15 g/cm³ in a more preferable embodiment. The bending strength of the susceptor 5 is 400 MPa or more, and 500 to 700 MPa in a more preferable embodiment.

Applications of the susceptor 5 obtained in the present embodiment are not particularly limited, but the susceptor having the advantageous properties described above can be used favorably in applications that demand high purity, gas resistance, heat resistance and high-speed rotation such as MOCVD (metal organic metal chemical vapor deposition) apparatuses.

Each of the silicon carbide powder (raw powder used in the embodiment), the silicon source and the non-metal sintering aid used in preparation of the raw powder, and the inert gas for making a non-oxidative atmosphere preferably has an impurity-element content of 1 ppm or less, but the purity may be lower than that, if it is in the range allowing purification in the heating or sintering step.

### (Modified embodiments)

The present invention has been described so far with reference to a preferable embodiment, but is not limited to the embodiment. Thus, although a horizontal susceptor was described in the embodiment, the susceptor is not limited thereto, and a vertical susceptor may also be used. The base plate 1 and the ring plate 2 may be prepared, not only by the hot pressing above, but also, for example, by reactive sintering.

### EXAMPLES

An Example of the present invention will be shown below, but it should be understood that the present invention is not limited by the Example.

### (Example)

A susceptor shown in Figures 1(a) to 1(c) was prepared by hot pressing. Sapphire wafers having a diameter of 50 mm and a thickness of 0.33 mm were placed in the wafer pockets. There was no dislocation of the wafers after continuous rotation of the susceptor at a rotational frequency in the range of from 0 rpm to 1,100 rpm for 15 minutes.

### (Comparative Example)

A susceptor shown in Figures 4(a) to 7(c) was prepared by hot pressing. Sapphire wafers having a diameter of 50 mm and a thickness of 0.33 mm were placed in the wafer pockets. There was dislocation of the wafers observed when the susceptor was rotated at an increasing rotational frequency from 0 rpm to 250 rpm.

As apparent from the results in the Example and the Comparative Example above, presence of a tapered area on the side wall of wafer pockets allows immobilization of wafers and is effective in preventing dislocation of the wafers.

### [Explanation of numerals]

- 1:: Base plate
- 2:: Ring plate
- 5:: Susceptor
- 21a to 211:: Wafer pocket
- 223:: Tapered area
- 3a to 311:: bolt
- W:: wafer
- 101:: Conventional susceptor
- 121a to 121f:: Conventional wafer pocket
- 122b:: Parabolic-crosssectioned tapered area of conventional susceptor

## Claims

1. A susceptor (5) **characterized by** including
a base plate (1) on which wafers are mounted and
a ring plate (2) detachably connected to the base plate (1) having hollow wafer pockets (21a-21f) for storing the wafers when connected to the base plate (1), wherein a tapered area (22b) is formed on the side wall of each wafer pocket (21a-21f) so that the opening diameter of the wafer pocket declines in the direction from the bottom to the top of the wafer pocket (21a-21f), wherein
the ring plate (2) is divided into a plurarity of units, each unit having at least one wafer pocket (21a-21f).

2. The susceptor according to Claim 1, wherein the inclination angle between the bottom face and the side wall of the wafer pocket in the tapered area (22b) is 60° to 85°.

3. The susceptor according to Claim 1 or 2, wherein the susceptor (5) is made of a sintered silicon carbide.

4. The susceptor according to Claim 1 or 2, wherein the susceptor (5) is made of a sintered nitrogen-containing silicon carbide.

## Patentansprüche

1. Suszeptor (5), **dadurch gekennzeichnet, dass** er Folgendes einschließt:
eine Grundplatte (1), auf der Halbleiterscheiben angebracht werden, und
eine abnehmbar mit der Grundplatte (1) verbundene Ringplatte (2), die hohle Halbleiterscheiben-Taschen (21a-21f) hat, welche die Halbleiterscheiben aufnehmen, wenn sie mit der Grundplatte (1) verbunden ist, wobei ein verjüngter Bereich (22b) an der Seitenwand jeder Halbleiterscheiben-Tasche (21a-21f) geformt ist, so dass sich der Öffnungsdurchmesser der Halbleiterscheiben-Tasche in der Richtung von der Unterseite zu der Oberseite der Halbleiterscheiben-Tasche (21a-21f) vermindert, wobei
die Ringplatte (2) in eine Vielzahl von Einheiten unterteilt ist, wobei jede Einheit wenigstens eine Halbleiterscheiben-Tasche (21a-21f) hat.

2. Suszeptor nach Anspruch 1, wobei der Neigungswinkel zwischen der Bodenfläche und der Seitenwand der Halbleiterscheiben-Tasche in dem verjüngten Bereich (22b) 60° bis 85° beträgt.

3. Suszeptor nach Anspruch 1 oder 2, wobei der Suszeptor (5) aus einem gesinterten Siliziumcarbid hergestellt ist.

4. Suszeptor nach Anspruch 1 oder 2, wobei der Suszeptor (5) aus einem gesinterten stickstoffhaltigen Siliziumcarbid hergestellt ist.

## Revendications

1. Suscepteur (5), **caractérisé en ce qu'**il englobe :
une plaque de base (1) sur laquelle sont montées des tranches ; et
une plaque annulaire (2), connectée de manière détachable à la plaque de base (1), comportant des poches de tranche creuses (21a-21f), assurant le stockage des tranches lors de la connexion à la plaque de base (1), une zone effilée (22b) étant formée sur la paroi latérale de chaque poche de tranche (21a-21f), de sorte que le diamètre d'ouverture de la poche de la tranche est réduit du bas vers le haut de la poche de la tranche (21a-21f), dans lequel
la plaque annulaire (2) est divisée en plusieurs unités, comportant chacune au moins une poche de tranche (21a-21f).

2. Suscepteur selon la revendication 1, dans lequel l'angle d'inclinaison entre la face inférieure et la paroi latérale de la poche de la tranche dans la région effilée (22b) est compris entre 60° et 85°.

3. Suscepteur selon les revendications 1 ou 2, dans lequel le suscepteur (5) est composé de carbure de silicium fritté.

4. Suscepteur selon les revendications 1 ou 2, dans lequel le suscepteur (5) est composé d'azote fritté contenant du carbure de silicium.
